**Europäisches Patentamt**

**European Patent Office**

**Office européen des brevets**

(19)

(11) Veröffentlichungsnummer: **0 205 746**
**B1**

(12) # EUROPÄISCHE PATENTSCHRIFT

(45) Veröffentlichungstag der Patentschrifft:
07.02.90

(21) Anmeldenummer: **86102317.4**

(22) Anmeldetag: **22.02.86**

(51) Int. Cl.⁵: **H 01 L 23/04,** H 01 L 25/04,
H 01 L 23/16

(54) Leistungshalbleitermodul mit Keramiksubstrat.

(30) Priorität: **15.06.85 DE 3521572**

(43) Veröffentlichungstag der Anmeldung:
**30.12.86 Patentblatt 86/52**

(45) Bekanntmachung des Hinweises auf die Patenterteilung:
**07.02.90 Patentblatt 90/06**

(84) Bennante Vertragsstaaten:
**DE FR GB IT NL**

(56) Entgegenhaltungen:
**EP-A-0 069 901**
**EP-A-0 108 646**
**DE-A-1 945 899**
**DE-A-3 323 246**
**FR-A-2 516 702**
**FR-A-2 535 898**

(73) Patentinhaber: **Asea Brown Boveri Aktiengesellschaft**
**Kallstadter Strasse 1**
**D-6800 Mannheim-Käfertal (DE)**

(72) Erfinder: **Neidig, Arno, Dr. Dipl.-Phys.**
**Brühlerweg 42**
**D-6831 Plankstadt (DE)**

(74) Vertreter: **Rupprecht, Klaus, Dipl.-Ing.**
**c/o Asea Brown Boveri Aktiengesellschaft**
**Zentralbereich Patente Postfach 100351**
**D-6800 Mannheim 1 (DE)**

## Beschreibung

Die Erfindung bezieht sich auf ein Leistungshalbleitermodul nach dem Oberbegriff des Anspruchs 1. Solche Leistungshalbleitermodule finden in der Stromrichtertechnik Anwendung.

Bei derartigen Leistungshalbleitermodulen wird die entstehende Verlustwärme über die Bodenfläche des Moduls zu einem Kühlkörper abgeführt. Damit eine gute Wärmeverteilung gewährleistet ist, muß die Auflage des Moduls auf dem Kühlkörper großflächig sein. Außerdem muß für ausreichenden Andruck des Substrats an den Kühlkörper gesorgt werden, insbesondere im Bereich von Verlustwärme erzeugenden Bauelementen. Besonders bei großflächigen Substraten ist es schwierig, über die ganze Auflage den erforderlichen Andruck sicherzustellen. Man kann eine leicht konvexe Durchbiegung des Substrats dadurch einstellen, daß die Metallschicht auf der Unterseite des Substrats etwas dünner ausgeführt wird, als auf der Oberseite. Diese Maßnahme ist jedoch nicht immer wirkungsvoll, da die oberseitige Strukturierung die Durchbiegung wesentlich beeinflußt. Ferner verursacht das Auflöten von Bauelementen zusätzliche Verbiegungen, deren Berücksichtigung bei der Einstellung der Durchbiegung sehr schwierig ist. Um diese Schwierigkeiten zu umgehen, sind Modulausführungen mit Abstützung des Substrats gegen das Gehäuse bekanntgeworden.

Aus der DE-OS-3 323 246 sind Abstützungen bekannt, die an das Kunststoffgehäuse angeformt sind. Dies erfordert jedoch eine Herstellung der Kunststoffgehäuse mit sehr engen Toleranzen. Besonders bei größeren Gehäusen ist es schwierig diese Toleranzen einzuhalten.

Aus der EP-A-0 069 901 ist ein Stromrichtermodul bekannt, das einen oben und unten offenen Rahmen, der als Gehäusewandung dient, besitzt. Das Gehäuse wird zum einen durch den Rahmen, zum anderen durch eine in eine Vertiefung der Bodenfläche des offenen Rahmens aufgesetzte Keramikplatte gebildet. Das Gehäuse wird in seinem unteren Teil mit einer weichen Vergußmasse vergossen. Das Verschließen des Gehäuses bis knapp über die Gehäusemitte erfolgt mit einer harten Vergußmasse, z. B. Epoxidharz.

Der Erfindung liegt deshalb die Aufgabe zugrunde, eine Abstützung anzugeben, die auf einfache Weise zu realisieren ist und die Nachteile bekannter Lösungen vermeidet.

Diese Aufgabe wird bei einem Leistungshalbleitermodul nach dem Oberbegriff des Anspruchs durch die kennzeichnenden Merkmale des Anspruchs 1 gelöst.

Vorteile der erfindungsgemäßen Lösung bestehen unter anderem darin, daß eine dauerhaft wirksame Abstützung mit einfachen Mitteln erreicht wird und keine Montage- oder Justiereinrichtungen benötigt werden. An die Gehäusetoleranzen werden keine hohen Anforderungen gestellt. Es ist vorteilhaft, wenn die vorgesehenen Stützen aus isolierendem Material bestehen, weil dann bei der Anordnung keine Rücksicht auf spannungsführende Teile genommen werden muß. Durch Rippen oder sonstige Anformungen am Gehäuse oberhalb von angeordneten Stützen kann auf vorteilhafte Weise die Fixierung der Stützen und deren Stützwirkung weiter verbessert werden.

Die Erfindung wird anhand eines Ausführungsbeispiels und der Zeichnung erläutert. Es zeigen:

Fig. 1  eine Sicht auf ein bestücktes Substrat und
Fig. 2  einen Schnitt durch ein vergossenes Modul entlang einer in Fig. 1 eingetragenen Schnittlinie A-B.

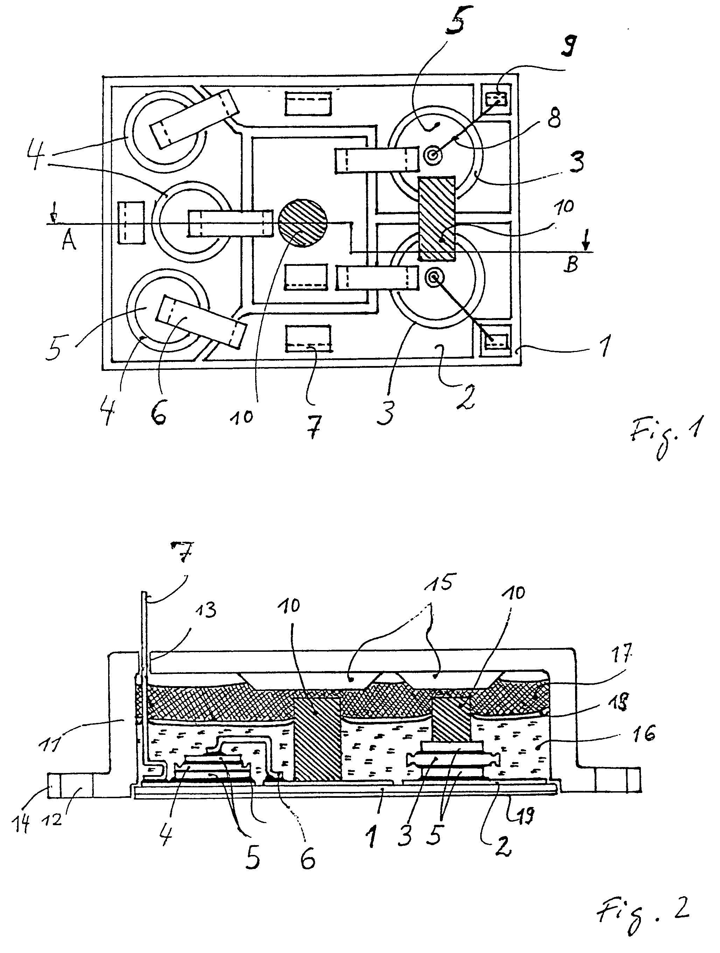

Fig. 1 zeigt als Beispiel eine halbgesteuerte Einphasenbrücke mit Freilaufdioden. Auf einem Keramiksubstrat 1 sind auf einer strukturierten Metallisierung 2 zwei Thyristoren 3 und drei Dioden 4 angeordnet. Oberhalb und unterhalb der Thyristoren 3 und Dioden 4 befinden sich Ausgleichsronden 5 aus Molybdän. Zur Kontaktierung der oben liegenden Kathodenseite der Thyristoren 3 und Dioden 4 sind zwischen den oberen Ausgleichsronden 5 und der strukturierten Metallisierung 2 metallische Klips 6 vorgesehen. Weiterhin sind auf der Metallisierung 2 Anschlußlaschen 7 angelötet, die einen Dehnungsbogen aufweisen. Von den Gate-Anschlüssen der Thyristoren 3 führen Drahtverbindungen 8 zu einem Flachsteckerfuß 9 für einen äußeren Gateanschluß.

Das beschriebene bestückte Substrat 1 kann in üblicher Weise hergestellt werden. Dabei geht man von einem metallisierten und entsprechend strukturierten Substrat 1 aus und lötet die Bauelemente 3, 4 und die Anschlußelemente 5 bis 9 auf. Das Substrat 1 ist auch auf der Unterseite mit einer Metallisierung 19 versehen (in Fig. 2 dargestellt). Die Metallisierungen 2 und 19 werden vorzugsweise durch direktes Verbinden von Kupfer mit Keramik hergestellt.

Nach dem letzten Weichlötprozeß werden Stützen 10 aus keramischem Material auf dem Substrat 1 befestigt. Der Ausdehnungskoeffizient des für Stützen 10 verwendeten Materials mit zweckmäßigerweise kleiner gewählt als derjenige der für Gehäuse und Vergießmassen verwendeten Kunststoffe. Dadurch ergibt sich nach dem Abkühlen eine leicht konvexe Durchbiegung des Substrats 1 an den Stellen, an denen Stützen 10 eingesetzt sind, wodurch ein guter thermischer Kontakt zu einem Kühlkörper erreicht ist. Material für die Stützen 10 sind preisgünstige Keramiken, wie z. B. $Al_2O_3$, Mullit oder Steatit. Die Auflagefläche der Stützen 10 auf dem Substrat 1 darf nicht punktförmig sein, da zu kleine Auflageflächen durch die auftretenden mechanischen Spannungen zu einer Beschädigung des Substrats 1 führen könnten.

Die Anordnung von Stützen 10 erfolgt bevorzugt in der Mitte des Substrats 1 und auf besonders belasteten Bauelementen 3, 4. Im dargestellten Beispiel ist eine Stütze 10 in der Substratmitte angeordnet und eine zweite Stütze 10 auf den oberen Ausgleichsronden 5 der beiden Thyristoren 3. Anstelle der dargestellten gemeinsamen Stütze 10 für die beiden Thyristoren 3 könnten selbstverständlich auch einzelne ringförmige Stützen 10 je Thyristor 3 verwendet werden. Die Stütze 10 würde man dann zweckmäßig zentrisch auf der Ausgleichsronde 5 anordnen und die Drahtverbindung 8 für den Gateanschluß durch eine Öffnung in der Stütze 10 führen.

Die Befestigung der Stützen 10 kann vorzugsweise mit Hilfe eines Klebstoffs erfolgen. Eine andere Möglichkeit zur Befestigung besteht z. B. darin, an den gewünschten Stellen Stifte anzulöten, auf die Stützen 10, die mit einer entsprechenden Öffnung versehen sind, aufgesteckt werden. Die Stütze 10 wird während des Vergießens nicht nach oben gedrückt, da ihr spezifisches Gewicht höher ist, als dasjenige der Vergießmasse. Selbstverständlich sind auch andere Befestigungsarten möglich, wie z. B. Auflöten von metallisierten Stützen 10.

Das Substrat 1 wird mit aufgeklebten Stützen 10 in ein Gehäuse eingeklebt. Falls es sich um ein Gehäuse handelt, das aus einem Rahmen und einem davon getrennten Deckel besteht, kann der Einbau der Stützen (kleben oder auf Stifte stecken) auch nach dem Einkleben des Substrats 1 in den Rahmen erfolgen.

In Fig. 2 ist ein Schnitt durch einen Modul mit einem haubenförmigen Gehäuse 11 dargestellt. Es handelt sich um einen Schnitt durch die in Fig. 1 eingetragene Ebene A-B. Das Gehäuse 11 hat Anformungen 14 mit Bohrungen 12 für Schrauben zur Befestigung des Moduls auf einem Kühlkörper. Auf der Oberseite hat das Gehäuse 11 Öffnungen 13 zur Durchführung von Anschlußelementen 7, 9 und zum Einfüllen von Vergießmasse. Außerdem weist das Gehäuse 11 an der Innenseite Rippen 15 auf. Die Länge der unterhalb von den Rippen 15 angeordneten Stützen 10 ist so gewählt, daß zwischen Rippen 15 und Stützen 10 ein Spalt von etwa 1 mm bleibt.

In die dargestellte Anordnung wird zuerst eine vorzugsweise elastomere Weichvergießmasse 16 eingefüllt und zwar eine solche Menge, daß die Stützen 10 etwa 1 bis 2 mm aus der Weichvergießmasse 16 herausragen. Nach dem Vernetzen der Weichvergießmasse 16 wird eine z. B. duroplastische Hartvergießmasse 17 eingefüllt, vorzugsweise ein Gießharz auf Epoxidbasis. Ein solches Harz härtet bei ca. 150°C aus und befestigt die Stützen 10 mit ihren oberen Teilen am Gehäuse 11 bzw. den Rippen 15. Nach dem Abkühlen des Moduls findet man eine ebene bis leicht konvexe Unterseite des Substrats 1 vor.

Die Stützen 10 verankern sich - wie bereits ausgeführt - in der Hartvergießmasse 17, die ihrerseits fest mit dem Gehäuse 11 verbunden ist. In den Spalt zwischen der Oberseite der Stützen 10 und Rippen 15 bzw. sonstigen Anformungen am Gehäuse 11 hat sich gerade soviel Hartvergießmasse 17 angesammelt wie notwendig ist, um eine ebene Bodenfläche am Modul zu erzielen. Dieser Effekt wird vornehmlich dadurch begünstigt, daß bei den Aushärtetemperaturen der Hartvergießmasse 17 bei etwa 150°C die durch den Verbindungsprozeß erzeugten Biegespannungen gerade verschwinden. Damit sich die Schrumpfung der Hartvergießmasse 17 nicht nachteilig auf den Stützeffekt auswirkt, darf der Spalt zwischen der Oberseite der Stützen 10 und Rippen 15 nicht zu groß sein. Deshalb wird eine Spaltweite von etwa 1mm bevorzugt. Außerhalb der Stützen 10 kann zwischen der Weichvergießmasse 16 und der Hartvergießmasse 17 durch Schrumpfung ein Spalt 18 entstehen, der jedoch für den Stützeffekt ohne Belang ist.

Nach dem Aushärten und Erkalten der Hartvergießmasse 17 wirkt die Längenschrumpfung des Kunststoffgehäuses 11 einem konkaven Durchbiegen des Substrats 1 entgegen. Da die Stützen 10 einen kleineren Ausdehnungskoeffizienten haben, wird eher eine leicht konvexe Wölbung des Substrats an den Stellen erreicht, an denen Stützen 10 eingesetzt sind. Dies fördert den guten thermischen Kontakt des Substrats zum Kühlkörper nach dem Festschrauben des Moduls. Die gewünschte Form der Bodenfläche des Moduls stellt sich wie beschrieben selbsttätig, d.h. ohne Verwendung von Montageplatten oder sonstigen Justierhilfen ein.

## Patentansprüche

1. Leistungshalbleitermodul, bestehend aus einem beidseitig metallisierten Keramiksubstrat, das auf der Oberseite mit Bauelementen bestückt, in ein Kunststoffgehäuse eingesetzt und mit Vergießmasse abgedeckt ist, *dadurch gekennzeichnet, daß*

- im Modul mindestens eine Stütze (10) auf dem Substrat (1) oder einem Bauelement (3, 4) angeordnet ist,
- als eine erste Weichvergießmasse (16) ein elastomerer Verguß vorgesehen ist, aus dem ein oberer Teil der Stütze bzw. Stützen (10) herausragt und
- als eine zweite Hartvergießmasse (17) ein duroplastischer Verguß vorgesehen ist, der den oberen Teil der Stütze bzw. Stützen (10) überdeckt und mit dem Gehäuse (11) verbindet.

2. Leistungshalbleitermodul nach Anspruch 1, dadurch gekennzeichnet, daß die Stützen aus isolierendem Material (z. B. Keramik) bestehen, deren Ausdehnungskoeffizient kleiner ist als derjenige des Kunststoffmaterials des Gehäuses (11) und der Vergießmassen (16, 17).

3. Leistungshalbleitermodul nach Anspruch 1 oder 2, dadurch gekennzeichnet, daß am Gehäuse (11) mindestens im Bereich oberhalb von Stützen (10) Anformungen oder Rippen (15) vorgesehen sind, zur Herstellung einer kraftschlüssigen Verbindung zwischen Stützen (10) und Gehäuse (11), wobei zwischen Stützen (10) und Gehäuse (11) bzw. Rippen (15) jeweils ein Spalt von vorzugsweise 1 mm Breite vorhanden ist, der sich mit der duroplastischen Vergießmasse (17) füllt.

4. Leistungshalbleitermodul nach einem der vorstehenden Ansprüche, dadurch gekennzeichnet, daß die Stützen (10) vor dem Vergießen auf dem Keramiksubstrat (1) oder den Bauelementen (3, 4) bzw. deren Ausgleichsronden (5) durch Kleben fixiert sind.

5. Leistungshalbleitermodul nach einem der Ansprüche 1 bis 3, dadurch gekennzeichnet, daß die Stützen (10) vor dem Vergießen auf dem Keramiksubstrat (1) oder den Bauelementen (3, 4) bzw. deren Ausgleichsronden (5) auf aufgelötete Stifte gesteckt sind.

## Claims

1. Power semiconductor module consisting of a ceramic substrate which is metallized on both sides and which is fitted with components at the top, inserted in a plastic housing and covered with casting compound, characterized in that

- at least one support (10) is arranged on the substrate (1) or a component (3, 4) in the module,
- an elastomeric casting is provided as a first soft casting compound (16) from which an upper part of the support or supports (10) protrudes, and
- a thermoset casting is provided as a second hard casting compound (17) which covers the top part of the support or supports (10) and adjoins it to the housing (11).

2. Power semiconductor module according to Claim 1, characterized in that the supports consist of insulating material (for example ceramic), the coefficient of expansion of which is smaller than that of the plastic material of the housing (11) and of the casting compounds (16, 17).

3. Power semiconductor module according to Claim 1 or 2, characterized in that moulded-on sections or ribs (15) are provided at least in the area above supports (10) at the housing (11), for producing a force-locked connection between supports (10) and housing (11), a gap of preferably 1 mm width, which fills with the thermoset casting compound (17) existing in each case between supports (10) and housing (11) or ribs (15).

4. Power semiconductor module according to one of the preceding Claims, characterized in that the supports (10) are fixed by cementing on the ceramic substrate (1) or the components (3, 4) or their compensating circles (5) before the casting.

5. Power semiconductor module according to one of Claims 1 to 3, characterized in that the supports (10) are pushed onto soldered-on pins on the ceramic substrate (1) or the components (3, 4) or their compensating circles (5) before the casting.

## Revendications

1. Module de puissance à semiconducteurs, composé d'un substrat en céramique métallisé de chaque côté qui est muni sur la face supérieure de composants, est mis en place dans un boîtier de matière plastique et est recouvert d'une masse d'enrobage, caractérisé en ce que

- au moins un support (10) est disposé dans le module sur le substrat (1) ou sur un composant (3, 4),
- il est prévu comme première masse molle d'enrobage (16) une masse élastomère de laquelle dépasse une partie supérieure du ou des support(s) (10) et
- il est prévu comme deuxième masse dure d'enrobage (17) une masse thermodurcissable qui recouvre la partie supérieure du ou des support(s) (10) et la relie au boîtier (11).

2. Module de puissance à semiconducteurs selon la revendication 1, caractérisé en ce que les supports sont composés d'un matériau isolant (de la céramique, par exemple) dont le coefficient de dilatation est inférieur à celui de la matière plastique du boîtier (11) et des masses d'enrobage (16, 17).

3. Module de puissance à semiconducteurs selon la revendication 1 ou 2, caractérisé en ce que des saillies ou nervures (15) sont prévues sur le boîtier (11), au moins dans la zone au-dessus de supports (10), pour réaliser une liaison par frottement entre les supports (10) et le boîtier (11), une fente qui présente de préférence une largeur de 1 mm et est remplie par la masse d'enrobage thermodurcissable (17) existant entre les supports (10) et le boîtier (11) ou les nervures (15).

4. Module de puissance à semiconducteurs selon l'une des revendications 1 à 3, caractérisé en ce que les supports (10) sont fixés, avant l'enrobage, par collage sur le substrat en céramique (1) ou les composants (3, 4) ou leurs disques de compensation (5).

5. Module de puissance à semiconducteurs selon l'une des revendications 1 à 3, caractérisé en ce que les supports (10) sont enfichés, avant l'enrobage sur des broches soudées sur le substrat en céramique (1) ou les composants (3, 4) ou leurs disques de compensation (5).

Fig. 1

Fig. 2